# EUROPÄISCHE PATENTSCHRIFT

(11) **EP 2 119 747 B1**
(45) Veröffentlichungstag und Bekanntmachung des Hinweises auf die Patenterteilung: **31.10.2012**
(21) Anmeldenummer: 09006049.2
(22) Anmeldetag: 02.05.2009
(51) Int. Cl.: C09D 11/00, H05K 3/12

(54) **Druckbare Zusammensetzung auf Basis von Silberpartikeln zur Erzeugung elektrisch leitfähiger Beschichtungen**
Printable compound based on silver particles for the creation of electrical conducting coatings
Composition imprimable à base de particules d'argent pour la production de revêtements conducteurs électriques

(30) Priorität: 16.05.2008 DE 102008023882
(43) Veröffentlichungstag der Anmeldung: 18.11.2009
(73) Patentinhaber: Bayer Intellectual Property GmbH, 40789 Monheim (DE)
(72) Erfinder: Bahnmüller, Stefan, Dr., 049514 Singapur (SG); Eiden, Stefanie, Dr., 51371 Leverkusen (DE); Meier, Stephan Michael, Dr., 41517 Grevenbroich (DE); Storch, Dirk, 51063 Köln (DE); Dunkel, Bernard, 51375 Leverkusen (DE)
(74) Vertreter: Bayer Intellectual Property GmbH

(56) Entgegenhaltungen:
- EP-A- 1 860 163
- WO-A-2004/067647
- WO-A-2006/076603
- DE-A1-102007 037 079
- HENDRIKS C E ET AL: "INVISIBLE SILVER TRACKS PRODUCED BY COMBINING HOT-EMBOSSING AND INKJET PRINTING" ADVANCED FUNCTIONAL MATERIALS, WILEY VCH, WIENHEIM, DE, Bd. 18, Nr. 7, 11. April 2008 (2008-04-11), Seiten 1031-1038, XP001511807 ISSN: 1616-301X

## Beschreibung

Die Erfindung betrifft eine Tinte zur Erzeugung elektrisch leitfähiger Druckbilder, auf Basis von nanoskaligen Silberpartikeln und mindestens einem polymeren Dispergierhilfsmittel in einer wässrigen Formulierung und ein Verfahren zu ihrer Herstellung. Die vorliegende Erfindung ermöglicht es durch das Auftragen der Formulierung mittels Sieb-, Flexo-, Gravur- oder Offset-Druckverfahren elektrisch leitfähige Strukturen auf Oberflächen darzustellen. Dies wird erreicht durch eine wässrige silberhaltige Formulierung, die neben Silber mindestens noch ein Polymer beinhaltet, durch Aufbringen mittels Sieb-, Flexo-, Gravur- oder Offset-Druck auf eine Oberfläche und abschließende thermische Behandlung der bedruckten Oberfläche, so dass sich eine Leitfähigkeit oder spiegelnde Oberfläche ergibt.

Es besteht ein prinzipieller Bedarf an elektrisch leitfähigen Strukturen auf Oberflächen von Gegenständen mit schlechter Oberflächenleitfähigkeit. Bezüglich der Leitfähigkeit sind z.B. Verwendungen bei der Integration von elektronischen Schaltkreisen in ein elektronisches Bauteil durch Aufdrucken von leitendem Material auf die Oberfläche des Bauteils wünschenswert. Hierdurch könnten aufwendige Verbundprobleme von Bauteilen mit gesonderten Schaltkreisen minimiert werden. Insbesondere ist die Bedruckung von Oberflächen flexibler Materialien mit elektrischen Leiterbahnen besonders interessant. Die Gestaltungsfreiheit des Gesamtbauteils mit flexiblem Anteil soll nicht mehr durch den vorgesehenen Schaltkreis beeinflusst werden.

Das Aufbringen von Leiterbahnen aus Kupfer ist lange Stand der Technik. Diese sind jedoch nur mit aufwendigen Abscheide- und Ätzverfahren auf Oberflächen applizierbar.

Eine Weiterentwicklung sind elektrisch leitende Pasten (Leitsilber), die nachträglich auf Oberflächen aufgetragen werden können und zur Kontaktierung Verwendung finden.

Besonderes Interesse besteht an der Bedruckung von Polymermaterialien. Während des Druckprozesses, mit dem die Oberfläche leitfähig gemacht wird, sollte die Oberfläche des Substrates nicht über den Erweichungspunkt (z.B. Glasübergangstemperatur einer Polymeroberfläche) des Oberflächenmaterials erwärmt werden. Es darf zudem kein Lösungsmittel verwendet werden, das die Oberfläche auflöst oder anlöst.

Bekannte Verfahren mit denen preiswert und in großem Durchsatz Strukturen auf Oberflächen aufgebracht werden können, sind das Siebdruck-, oder Offset-Druckverfahren. Diese beiden Verfahren stellen jedoch weitere Anorderungen an die verwendete Drucksubstanz. So ist dem Fachmann bekannt, dass Tinten, oder Farben, die mit diesen Druckverfahren verwendet werden sollen, Mindestanforderungen an die Viskosität der Drucktinte stellen. Die Viskosität muss im Bereich oberhalb von 1 Pa·s liegen, damit gute Druckergebnisse erzielt werden können.

Die Patente US-A-5,882,722 und US-A-6,036,889 beschreiben leitfähige Formulierungen, die metallische Partikel, einen Precursor und ein organisches Lösungsmittel enthalten und die erst bei einer Sintertemperatur ab 200 °C leitfähige Strukturen bilden. Diese bekannten Formulierungen haben eine Viskosität von etwa 10 Pa·s. Die Formulierung ist zwar für die beschriebenen Drucktechnologien (Siebdruck, Offsetdruck) verwendbar, allerdings ist aufgrund der notwendigen hohen Sintertemperatur die Verwendbarkeit für die Anwendung auf Oberflächen von Polymeren eingeschränkt.

Die Schriften WO-2003/038002 und US-A-2005/0078158 offenbaren Formulierungen mit Silbemanopartikeln, die unter anderem mit Natrium-Cellulosemethylcarbonsäure stabilisiert werden. In diesen Schriften werden zwar die Notwendigkeit der Nachbehandlung z.B. durch Wärme, oder Flockungsmittel beschrieben, jedoch weder Verarbeitungstemperatur noch die Leitfähigkeit der aus der Formulierung erhaltenen Mikrostrukturen beschrieben. Weiterhin wird die genaue Verteilung der verwendeten und erhaltenen Nanopartikel nicht offenbart, wenngleich der Bereich der Größe kleiner 100 nm beträgt. Der Gehalt an Silberpartikeln der offenbarten Formulierungen beträgt nicht mehr als 1,2 Gew-%. Die für das vorgesehene Inkjetverfahren typischerweise notwendige Viskosität der Druckformulierung liegt bei etwa 10 mPa·s. Die Formulierung ist daher für den Sieb- oder Offsetdruck kaum verwendbar.

In EP 1586604 wird eine Silberpaste offenbart, die sich aus einem Epoxid-Harz, Silberflakes und Silber-Nanopartikeln zusammensetzt. Diese Paste bildet nach Drucken oder Aufbringen auf die Oberfläche eines Basismaterials und anschließender Wärmebehandlung einen leitfähigen Film. Bei Sintertemperaturen über 200 °C werden Widerstände von kleiner 5x10⁵ Ohm/cm erreicht. Diese hohe Sintertemperatur schränkt die Auswahl der bedruckbaren Polymersubstrate stark ein.

In WO 2008/031015 wird eine wässrige Formulierung offenbart, die ebenfalls Silberflakes enthält. Mit dieser Formulierung können bei 120°C Leitfähigkeiten von 0,022 Ohm/square erreicht werden.

Die Firma HARIMA bietet die Produktlinie "NP Series Nano-Paste" an, bei der es sich um eine Silberleittinte auf Nanopartikelbasis mit niedriger Viskosität handelt. HARIMA gibt allerdings Sintertemperaturen von 210-230°C an.

Es ist also eine bislang ungelöste Aufgabe eine leitfähige Formulierung bereit zu stellen, die unter Verwendung von elementarem Silber leitfähige Strukturen auf insbesondere thermisch labilen Oberflächen unter Verwendung der Offset- oder Siebdrucktechnologie darstellbar macht. Niedrige Temperaturen umfassen in diesem Zusammenhang z.B. Temperaturen, die unterhalb der Glasübergangstemperatur der Polymeroberfläche liegen (PVC ∼ 80°C).

Die vorstehende Aufgabe wird in dieser Erfindung mittels einer silberhaltigen Formulierung gelöst, die mittels Sieb-, Flexo-, Gravur- oder Offsetdruck auf eine Oberfläche gebracht werden kann und auf dieser mittels thermischer Weiterbehandlung bei Temperaturen ≤ 140°C, möglichst kleiner 100°C versintert werden kann, um leitfähige Strukturen zu erhalten.

Gegenstand der Erfindung ist eine druckbare Zusammensetzung zur Erzeugung elektrisch leitfähiger Beschichtungen auf Basis in Wasser dispergierter Silberpartikel, wenigstens umfassend
a) von 5 bis 40 Gew.-Teile Silbermetallpartikel mit einem effektiven Durchmesser von höchstens 150 nm, bevorzugt von höchstens 100 nm, besonders bevorzugt von 20 bis 80 nm, ganz besonders bevorzugt von 40 bis 80 nm, ermittelt mit der Laserkorrelationsspektroskopie, wobei die Silberpartikel insbesondere eine bimodale Größenverteilung aufweisen
b) von 50 bis 99,5 Gew.-Teile Wasser und gegebenenfalls bis zu 30 Gew.-Teile Lösungsmittel,
c) von 0,01 bis 15 Gew. -Teile wenigstens eines, insbesondere polymeren Dispergierhilfsmittels,
e) von 0 bis 5 Gew.- Teile Additive, bevorzugt 0,5 bis 5 Gew.- Teile, besonders bevorzugt 1 bis 4 Gew.- Teile Additive
f) von 0 bis 5 Gew.-Teile leitfähige, gegebenenfalls wasserlösliche Polymere, bevorzugt 0,5 bis 5 Gew.- Teile, besonders bevorzugt 1 bis 4 Gew.- Teile leitfähige Polymere
   **dadurch gekennzeichnet, dass** die Formulierung
d) von 0,5 bis 5 Gew.- Teile, bevorzugt 1 bis 4 Gew.- Teile Verdicker,
g) und von 30 bis 70 Gew.-Teile Metallpartikel mit einem effektiven Durchmesser von 500 nm - 10 µm, bevorzugt Silberpartikel oder Kupferpartikel, die mit Silber ummantelt sind,
   und eine Viskosität von mindestens 1 Pa•s aufweist.

Die Summe der Gewichtsteile der Komponenten der Formulierung beträgt insbesondere 100 Gewichtsteile.

Die Größenbestimmung mittels Laserkorrelationsspektroskopie ist literaturbekannt und z. B. beschrieben in T. Allen, Particle Size Measurements, Bd. 1., Kluver Academic Publishers, 1999.

Bevorzugt umfasst das Dispergierhilfsmittel wenigstens ein Mittel ausgewählt aus der Gruppe: Alkoxylate, Alkylolamide, Ester, Aminoxide, Alkylpolyglukoside, Alkylphenole, Arylalkylphenole, wasserlösliche Homopolymere, wasserlösliche statistische Copolymere, wasserlösliche Blockcopolymere, wasserlösliche Pfropfpolymere, insbesondere Polyvinylalkohole, Copolymere aus Polyvinylalkoholen und Polyvinylacetaten, Polyvinylpyrrolidone, Cellulose, Stärke, Gelatine, Gelatinederivate, Aminosäurepolymere, Polylysin, Polyasparaginsäure, Polyacrylate, Polyethylensulfonate, Polystyrolsulfonate, Polymethacrylate, Kondensationsprodukte von aromatischen Sulfonsäuren mit Formaldehyd, Naphthalinsulfonate, Ligninsulfonate, Copolymerisate acrylischer Monomere, Polyethylenimine, Polyvinylamine, Polyallylamine, Poly(2-vinylpyridine), Block-Copolyether, Block-Copolyether mit Polystyrolblöcken und/oder Polydiallyldimethylammoniumchlorid ist.

Das Dispergierhilfsmittel ist besonders bevorzugt ausgewählt aus der Reihe: Polyvinylpyrrolidon, Blockcopolyether und Blockcopolyether mit Polystyrolblöcken. Ganz besonders bevorzugt werden Polyvinylpyrrolidon mit einer Molmasse von etwa 8000 amu bis 400000 amu (z. B. PVP K15 ein Polyvinylpyrrolidon mit Molmasse von 10000 amu der Firma Fluka oder PVP K90 (Molmasse von etwa 360000 amu) der Firma Fluka) und besonders bevorzugt auch Block-Copolyether mit Polystyrolblöcken, mit 62 Gew.-% C₂-Polyether, 23 Gew.-% C₃-Polyether und 15 Gew.-% Polystyrol, bezogen auf das getrocknete Dispergierhilfsmittel, mit einem Verhältnis der Blocklängen C₂-Polyether zu C₃-Polyether von 7:2 Einheiten (z. B. Disperbyk 190 der Firma BYK-Chemie, Wesel) eingesetzt.

Besonders bevorzugt wird ein Lösungsmittel b) ausgewählt aus der Reihe: C₁- bis C₅-Alkohol, insbesondere C₁- bis C₃-Alkohol, Ether, insbesondere Dioxalan, Glykole, insbesondere Glycerol, Ketone, insbesondere Aceton, verwendet.

Der Filmbildner d) ist bevorzugt ausgewählt aus der Reihe: Polydimethylsiloxan, Polyacrylat, Ammoniumsalze von Polyacrylaten, Siloxane, Wachskombinationen, Copolymere mit pigmentaktiven Gruppen, niedermolekulare Polymere, modifizierte Cellulose, insbesondere Hydroxyethylcellulose oder Methylcellulose, Kohlenstoffnanoröhrchen und Polyvinylalkohol, bevorzugt Hydroxyethylcellulose, Methylcellulose und Kohlenstoffnanoröhrchen. Weitere bevorzugte Filmbildner d) sind aus der Gruppe der weiter oben genannten Dispergierhilfsmittel, hier besonders bevorzugt z. B. das Dispergierhilfsmittel BYK 356 der Firma BYK-Chemie, Wesel, ein Polyacrylat sowie das BYK 154 derselben Firma, das Ammoniumsalz eines Acrylatcopolymeren, ausgewählt. Die Filmbildner d) können auch in beliebigen Kombinationen angewendet werden, bevorzugt ist eine Kombination von Hydroxyethylcellulose und/oder Methylcellulose mit Kohlenstoffnanoröhrchen einzusetzen.

Das Additiv e) ist bevorzugt ausgewählt aus der Reihe: Pigmente, Entschäumer, Lichtschutzmittel, optische Aufheller, Korrosionsinhibitor, Antioxidantien, Algizide, Weichmacher, Verdicker, oberflächenaktive Substanzen. Besonders bevorzugt ist das Additiv ein Reduktionsmittel, wie z.B.

Formaldehyd, Glycerin, Ascorbinsäure etc. Ganz besonders bevorzugt wird Formaldeyd als Additiv eingesetzt.

Das leitfähige Polymer f) ist bevorzugt gewählt aus der Reihe: Polypyrrol, Polyanilin, Polythiophen, Polyphenylenvinylen, Polyparaphenylen, Polyethylendioxythiophen, Polyfluoren, Polyacetylen, besonders bevorzugt Polyethylendioxythiophen in Kombination mit Polystyrolsulfonsäure. Bei einem leitfähigen Salz handelt sich bevorzugt um eine sogenannte ionische Flüssigkeit, insbesondere um Salze des Typs: Tetra-alkylammonium, Pyridinium, Imidazolium, Tetraalkylphosphonium mit fluorierten Anionen.

Eine besonders bevorzugte Formulierung ist **dadurch gekennzeichnet, dass** die Silberpartikel a) einen effektiven Partikeldurchmesser von 10 bis 150 nm aufweisen, bevorzugt von 20 bis 80 nm, besonders bevorzugt von 40 bis 80 nm. Bei dem effektiven Partikeldurchmesser handelt es sich um den mittleren Partikeldurchmesser ermittelt mit der Laserkorrelationsspektrokopie (geeignetes Gerät beispielsweise Brookhaven BIC-90 Plus).

Die Silberpartikel a) sind bevorzugt in der Formulierung zu einem Anteil von 10 bis 35 Gew.-Teilen, besonders bevorzugt 15 bis 30 Gew.-Teilen enthalten. Der Gehalt an Dispergierhilfsmittel c) beträgt bevorzugt 0,1 bis 15 Gew.-Teile, besonders bevorzugt 5 bis 10 Gew.- Teile.

Es erscheint ebenfalls vorteilhaft, wenn die verwendeten Partikel in der endgültigen Formulierung dazu in der Lage sind dichte Packungen zu bilden, die bereits bei geringen Konzentrationen und Verarbeitungstemperaturen zur gewünschten Leitfähigkeit der gedruckten Struktur führen. Die Anforderung der geringen Konzentration hat hierbei rein wirtschaftliche Hintergründe. Je geringer der Anteil der Partikel bei gleicher oder ähnlicher Leitfähigkeit gehalten werden kann, desto geringer sind die Materialkosten der resultierenden Formulierung. Ein Ersatz möglichst großer Gewichtsanteile an Partikeln durch andere Materialien ist daher wünschenswert.

Gegenstand der Erfindung ist ferner die Verwendung der erfindungsgemäßen Zusammensetzung zur Erzeugung von elektrisch leitenden Beschichtungen, insbesondere von Leiterbahnen.

Gegenstand der Erfindung ist auch ein Verfahren zur Erzeugung von Leiterbahnen, das dadurch gekennzeichnet ist, dass die neue Formulierung mit Hilfe der Siebdruck-, Flexodruck-, Garvurdruck- oder Offsetdrucktechnik auf eine Substratoberfläche gedruckt und insbesondere bei einer Temperatur von höchstens 140 °C, bevorzugt höchstens 100 °C zur Entfernung von Wasserresten und gegebenenfalls Lösungsmitteln sowie gegebenenfalls zur Sinterung vorhandener Silberpartikel wärmebehandelt wird.

Eine besonders bevorzugte Formulierung ist **dadurch gekennzeichnet, dass** sie Silberpartikel von unterschiedlicher Größe verwendet. Es wurde überraschend gefunden, dass eine derartige Verteilung vorteilhaft für eine Ausbildung leitfähiger Strukturen bereits bei niedrigeren Gehalten der Silbemano-Partikel ist. Es ist anzunehmen, dass dies bedingt wird durch die Füllung der entstehenden Zwickelvolumina zwischen den größeren Partikeln durch kleinere. Hierdurch entstehen bei der thermischen Nachbehandlung der Tinte größere, durchgängige Kontaktflächen. Somit erreicht die resultierende Formulierung bei niedrigerem Massegehalt die gleiche Leitfähigkeit einer Tinte mit annähernd monodisperser Verteilung bei annähernd gleichem effektivem Durchmesser, oder eine höhere bei gleichem Massegehalt und gleichem effektivem Durchmesser.

Gegenstand der Erfindung ist weiterhin ein Substrat, insbesondere transparentes Kunststoffsubstrat aufweisend eine elektrisch leitende Beschichtung erhältlich aus einer Zusammensetzung gemäß der Erfmdung. Bevorzugt ist ein Substrat, bei dem die elektrisch leitende Beschichtung Leiterbahnen mit einer Leitfähigkeit von mindestens 5•10⁵ S/m umfasst.

Erfüllt werden die oben beschriebenen Anforderungen weiterhin durch eine Formulierung, die Silbernanopartikel, Silberpartikel, Lösungsmittel, Filmbildner, Dispergierhilfsmittel und Additive enthält. Vorzugsweise enthält sie kleine Silbernanopartikel, die - im wesentlichem - einen effektiven Durchmesser von 20 bis 80 nm, besonders bevorzugt von 40 bis 80 nm mit einer bimodalen Verteilung in einer Konzentration von 5 bis 40 Gew.-%, bevorzugt von 15 bis 30 Gew.-% enthalten. Die Formulierung kann zum Beispiel auf Polycarbonat aufgebracht werden, anschließend getrocknet und bei mindestens 80°C mehrere Minuten getempert werden. Man erhält dann sehr gut haftende, elektronisch leitfähige Strukturen beziehungsweise, bei einem flächigen Auftrag, optisch reflektierende Schichten, beide mit hohem Haftvermögen auf Polycarbonat.

Die in der Formulierung bevorzugt verwendeten Silbersole werden aus Ag₂O durch Reduktion mit einem Reduktionsmittel wie wässriger Formaldehydlösung (FA) nach vorhergehender Zugabe eines Dispergierhilfsmittels hergestellt. Dazu werden die Ag₂O-Sole zum Beispiel durch schnelles Vermischen von Silbernitratlösung mit NaOH durch schnelles Rühren batchweise oder durch Verwendung eines Mikromischers entsprechend der noch unveröffentlichten deutschen Patentanmeldung mit dem Aktenzeichen 10 2006 017 696 in einem kontinuierlichen Prozess hergestellt. Anschließend werden die Ag₂O-Nanopartikel mit FA im Überschuss in einem Batch-Verfahren reduziert und abschließend durch Zentrifugation oder Membranfiltration, bevorzugt durch Membranfiltration, gereinigt. Besonderes vorteilhaft ist diese Produktionsweise, weil die Menge an auf der Oberfläche der Nanopartikel gebundenen organischen Hilfsmitteln hierbei gering gehalten und weiterhin eine bimodale Größenverteilung erhalten werden kann. Insbesondere werden hierdurch keine Vorbehandlungsschritte, wie z.B. eine Vorreduktion in Gegenwart von Polymeren, oder weitere Nachbehandlungsschritte außer Energieeintrag, wie z.B. Aktivierung eines Precursor-Systems, oder Flokulation benötigt.

### Beispiel 1: (Herstellung von Nanosilber)

Es wurden eine 0,054 molare Silbernitratlösung mit einer Mischung aus einer 0,054 molaren Natronlauge und dem Dispergierhilfsmittel Disperbyk 190 (Hersteller BYK Chemie) (1 g/l) in einem Volumenverhältnis von 1:1 1 versetzt und 10 min gerührt. Zu dieser Reaktionsmischung wurde unter Rühren eine wässrige 4,6 molare Formaldehyd-Lösung zugesetzt, so dass das Verhältnis Ag⁺ zu Reduktionsmittel 1:10 beträgt. Diese Mischung wurde auf 60°C erwärmt, 30 min bei dieser Temperatur gehalten und anschließend abgekühlt. Die Partikel wurden in einem ersten Schritt mittels Diafiltration von den nicht umgesetzten Edukten getrennt und anschließend wurde das Sol aufkonzentiert, dazu wurde eine Membran mit 30000 Dalton benutzt. Es entstand ein kolloidstabiles Sol mit einem Feststoffgehalt von 20 Gew.-% (Silberpartikel und Dispergierhilfsmittel). Der Anteil an Disperbyk 190 betrug laut Elementaranalyse nach der Membranfiltration 6 Gew.-% bezogen auf den Silbergehalt. Eine Untersuchung mittels Laserkorrelationsspektroskopie (Brookhaven BIC-90 Plus) ergab einen effektiven Partikeldurchmesser von 78 nm.

### Beispiel 2:

In 15 ml 20% Nanosilber-Sol aus Beispiel 1 werden 1,5 g PVP K40 (der Firma SIGMA-ALDRICH) und 1,5 Disperbyk 190 (Altana, Byk-Additives) gelöst. Anschließend werden 30 g Silber-Pulver (Metalor K-1332 P) mittels Ultraschallfinger (G. Heinemann, Ultraschal und Labortechnik) bei einer Amplitude von 30% der Maximalleistung in die Mischung eingebracht. Die Paste wird anschließend mittels Siebdruck auf eine Polycarbonat-Folie (Makrolon^{®}, Bayer MaterialScience AG) aufgebracht und bei 130 °C getempert. Es wird eine spezifische Leitfähigkeit von 2x10⁶ S/m erreicht.

## Patentansprüche

1. Druckbare Zusammensetzung zur Erzeugung elektrisch leitfähiger Beschichtungen auf Basis in Wasser dispergierter Silberpartikel, wenigstens umfassend
a) von 5 bis 40 Gew.-Teile Silbermetallpartikel mit einem effektiven Durchmesser von höchstens 150 nm ermittelt mit der Laserkorrelationsspektrokopie, wobei die Silberpartikel insbesondere eine bimodale Größenverteilung aufweisen
b) von 50 bis 99,5 Gew.-Teile Wasser und gegebenenfalls bis zu 30 Gew.-Teile Lösungsmittel,
c) von 0,01 bis 15 Gew. -Teile wenigstens eines Dispergierhilfsmittels,
e) von 0 bis 5 Gew.-Teile Additive
f) von 0 bis 5 Gew.-Teile leitfähige Polymere
**dadurch gekennzeichnet, dass** die Formulierung
d) von 0,5 bis 5 Gew.-Teile Filmbildner,
g) und 30- 70 Gew.-Teile Metallpartikel mit einem effektiven Durchmesser von 500 nm bis 10 µm
und eine Viskosität von mindestens 1 Pa.s aufweist.

2. Zusammensetzung nach Anspruch 1, **dadurch gekennzeichnet, dass** das Dispergierhilfsmittel c) wenigstens ein Mittel ausgewählt aus der Reihe: Alkoxylate, Alkylolamide, Ester, Aminoxide, Alkylpolyglukoside, Alkylphenole, Arylalkylphenole, wasserlösliche Homopolymere, wasserlösliche statistische Copolymere, wasserlösliche Blockcopolymere, wasserlösliche Pfropfpolymere ist.

3. Zusammensetzung nach Anspruch 1 oder 2, **dadurch gekennzeichnet, dass** das Dispergierhilfsmittel ausgewählt ist aus der Reihe: Block-Copolyether und Block-Copolyether mit Polystyrolblöcken.

4. Zusammensetzung nach einem der Ansprüche 1 bis 3, **dadurch gekennzeichnet, dass** das weitere Lösungsmittel b) ausgewählt ist aus der Reihe: C₁ bis C₅-Alkohol, Ether, Glykole, Ketone.

5. Zusammensetzung nach einem der Ansprüche 1 bis 4, **dadurch gekennzeichnet, dass** der Filmbildner d) ausgewählt ist aus der Reihe: Polyacrylat, Ammoniumsalze von Polyacrylaten, Siloxane, Polyethylenglykol, Wachskombinationen, niedermolekulare Polymere, Hydroxyethylcellulose und/oder Methylcellulose mit oder ohne Kohlenstoffnanoröhrchen und Polyvinylalkohol.

6. Zusammensetzung nach einem der Ansprüche 1 bis 4, **dadurch gekennzeichnet, dass** der Filmbildner d) eine Mischung aus Hydroxyethylcellulose, und Kohlenstoffnanoröhrchen ist.

7. Zusammensetzung nach einem der Ansprüche 1 bis 6, **dadurch gekennzeichnet, dass** das Additiv e) ausgewählt ist aus der Reihe: Pigmente, Entschäumer, Lichtschutzmittel, optische Aufheller, Korrosionsinhibitor, Antioxidantien, Algizide, Weichmacher und Verdicker, oberflächenaktive Substanzen.

8. Zusammensetzung nach einem der Ansprüche 1 bis 7, **dadurch gekennzeichnet, dass** das leitfähige Polymer f) ausgewählt ist aus der Reihe: Polypyrrol, Polyanilin, Polythiophen, Polyphenylenvinylen, Polyparaphenylen, Polyethylendioxythiophen, Polyfluoren, Polyacetylen.

9. Zusammensetzung nach einem der Ansprüche 1 bis 8, **dadurch gekennzeichnet, dass** die Silberpartikel a) zu einem Anteil von 10 bis 35 Gew.-Teilen enthalten sind.

10. Zusammensetzung nach einem der Ansprüche 1 bis 9, **dadurch gekennzeichnet, dass** der Gehalt an Dispergierhilfsmittel c) 0,1 bis 15 Gew.-Teile beträgt.

11. Verwendung der Zusammensetzung nach einem der Ansprüche 1 bis 10 zur Erzeugung von elektrisch leitenden Beschichtungen.

12. Verfahren zur Erzeugung von Leiterbahnen, **dadurch gekennzeichnet, dass** eine Zusammensetzung nach einem der Ansprüche 1 bis 10 mit Hilfe der Siebdruck-, Flexodruck, Gravurdruck oder Offsetdrucktechnik auf eine Substratoberfläche gedruckt und zur Entfernung von Wasser und gegebenenfalls Lösungsmittel wärmebehandelt wird.

13. Substrat, aufweisend eine elektrisch leitende Beschichtung erhältlich aus einer Zusammensetzung nach einem der Ansprüche 1 bis 10.

14. Substrat nach Anspruch 13, **dadurch gekennzeichnet, dass** die elektrisch leitende Beschichtung Leiterbahnen mit einer Leitfähigkeit von mindestens 5·10⁴ S/m umfasst.

## Claims

1. Printable composition for production of electrically conductive coatings based on water-dispersed silver particles, at least comprising
a) from 5 to 40 parts by weight of silver metal particles having an effective diameter of at most 150 nm, determined by laser correlation spectroscopy, the silver particles having especially a bimodal size distribution,
b) from 50 to 99.5 parts by weight of water and optionally up to 30 parts by weight of solvent,
c) from 0.01 to 15 parts by weight of at least one dispersing aid,
e) from 0 to 5 parts by weight of additives,
f) from 0 to 5 parts by weight of conductive polymers,
**characterized in that** the formulation comprises
d) from 0.5 to 5 parts by weight of film formers,
g) and 30-70 parts by weight of metal particles having an effective diameter of 500 nm to 10 µm,
and has a viscosity of at least 1 Pa·s.

2. Composition according to Claim 1, **characterized in that** the dispersing aid c) is at least one aid selected from the group of: alkoxylates, alkylolamides, esters, amine oxides, alkyl polyglucosides, alkylphenols, arylalkylphenols, water-soluble homopolymers, water-soluble random copolymers, water-soluble block copolymers, water-soluble graft polymers.

3. Composition according to Claim 1 or 2, **characterized in that** the dispersing aid is selected from the group of: block copolyethers and block copolyethers having polystyrene blocks.

4. Composition according to any of Claims 1 to 3, **characterized in that** the further solvent b) is selected from the group of: C₁ to C₅ alcohol, ethers, glycols, ketones.

5. Composition according to any of Claims 1 to 4, **characterized in that** the film former d) is selected from the group of: polyacrylate, ammonium salts of polyacrylates, siloxanes, polyethylene glycol, wax combinations, low molecular weight polymers, hydroxyethyl cellulose and/or methyl cellulose with or without carbon nanotubes and polyvinyl alcohol.

6. Composition according to any of Claims 1 to 4, **characterized in that** the film former d) is a mixture of hydroxyethyl cellulose and carbon nanotubes.

7. Composition according to any of Claims 1 to 6, **characterized in that** the additive e) is selected from the group of: pigments, defoamers, light stabilizers, optical brighteners, corrosion inhibitors, antioxidants, algicides, plasticizers and thickeners, surface-active substances.

8. Composition according to any of Claims 1 to 7, **characterized in that** the conductive polymer f) is selected from the group of: polypyrrole, polyaniline, polythiophene, polyphenylenevinylene, polyparaphenylene, polyethylenedioxythiophene, polyfluorene, polyacetylene.

9. Composition according to any of Claims 1 to 8, **characterized in that** the silver particles a) are present in a proportion of 10 to 35 parts by weight.

10. Composition according to any of Claims 1 to 9, **characterized in that** the content of dispersing aid c) is 0.1 to 15 parts by weight.

11. Use of the composition according to any of Claims 1 to 10 for production of electrically conductive coatings.

12. Process for production of conductor tracks, **characterized in that** a composition according to any of Claims 1 to 10 is printed onto a substrate surface with the aid of screen printing, flexographic printing, gravure printing or offset printing technology and is heat-treated for removal of water and any solvent.

13. Substrate having an electrically conductive coating obtainable from a composition according to any of Claims 1 to 10.

14. Substrate according to Claim 13, **characterized in that** the electrically conductive coating comprises conductor tracks having a conductivity of at least 5.10⁴ S/m.

## Revendications

1. Composition imprimable pour générer des revêtements électriquement conducteurs à base de particules d'argent dispersées dans l'eau, comprenant au moins
a) 5 à 40 parties en poids de particules d'argent métallique présentant un diamètre effectif d'au plus 150 nm, déterminé par spectroscopie de corrélation au laser, les particules d'argent présentant en particulier une répartition bimodale des tailles
b) 50 à 99,5 parties en poids d'eau et le cas échéant jusqu'à 30 parties en poids de solvant,
c) 0,01 à 15 parties en poids d'au moins un adjuvant de dispersion,
e) 0 à 5 parties en poids d'additifs
f) 0 à 5 parties en poids de polymères conductibles **caractérisée en ce que** la formulation contient d) 0,5 à 5 parties en poids d'agent filmogène,
g) 30 à 70 parties en poids de particules métalliques, présentant un diamètre effectif de 500 nm à 10 µm
et une viscosité d'au moins 1 Pa.s.

2. Composition selon la revendication 1, **caractérisée en ce que** l'adjuvant de dispersion c) est au moins un agent choisi dans la série : alcoxylates, alkylolamides, esters, oxydes d'amine, alkylpolyglucosides, alkylphénols, arylalkylphénols, homopolymères solubles dans l'eau, copolymères statistiques solubles dans l'eau, copolymères à blocs solubles dans l'eau, polymères greffés solubles dans l'eau.

3. Composition selon la revendication 1 ou 2, **caractérisée en ce que** l'adjuvant de dispersion est choisi dans la série : copolyéthers à blocs et copolyéthers à blocs avec des blocs de polystyrène.

4. Composition selon l'une quelconque des revendications 1 à 3, **caractérisée en ce que** l'autre solvant b) est choisi dans la série . C₁-C₅-alcools, éthers, glycols, cétones.

5. Composition selon l'une quelconque des revendications 1 à 4, **caractérisée en ce que** l'agent filmogène d) est choisi dans la série : polyacrylates, sels d'ammonium de polyacrylates, siloxanes, polyéthylèneglycols, combinaisons de cires, polymères de bas poids moléculaire, hydroxyéthylcellulose et/ou méthylcellulose avec ou sans nanotubes en carbone et poly(alcool vinylique).

6. Composition selon l'une quelconque des revendications 1 à 4, **caractérisée en ce que** l'agent filmogène d) est un mélange d'hydroxyéthylcellulose et de nanotubes de carbone.

7. Composition selon l'une quelconque des revendications 1 à 6, **caractérisée en ce que** l'additif e) est choisi dans la série : pigments, antimousses, agents de protection contre la lumière, azurants optiques, inhibiteurs de corrosion, antioxydants, algicides, plastifiants et épaississants, substances tensioactives.

8. Composition selon l'une quelconque des revendications 1 à 7, **caractérisée en ce que** le polymère conductible f) est choisi dans la sérine : polypyrrole, polyaniline, polythiophène, polyphénylènevinylène, polyparaphénylène, polyéthylènedioxythiophène, polyfluorène, polyacétylène.

9. Composition selon l'une quelconque des revendications 1 à 8, **caractérisée en ce que** les particules d'argent a) sont contenues en une proportion de 10 à 35 parties en poids.

10. Composition selon l'une quelconque des revendications 1 à 9, **caractérisée en ce que** la teneur en adjuvants de dispersion c) est de 0,1 à 15 parties en poids.

11. Utilisation de la composition selon l'une quelconque des revendications 1 à 10 pour générer des revêtements électriquement conducteurs.

12. Procédé pour générer des pistes conductrices, **caractérisé en ce qu'**une composition selon l'une quelconque des revendications 1 à 10 est imprimée sur une surface de substrat par sérigraphie, par un procédé flexo, par gravure ou par une technique offset et est traitée thermiquement pour éliminer l'eau et le cas échéant le solvant.

13. Substrat, présentant un revêtement électriquement conducteur pouvant être obtenu à partir d'une composition selon les revendications 1 à 10.

14. Substrat selon la revendication 13, **caractérisé en ce que** le revêtement électriquement conducteur comprend des pistes conductrices présentant une conductibilité d'au moins 5 * 10⁴ S/m.
